(19)

Europäisches Patentamt
European Patent Office
Office européen des brevets

(11) **EP 2 393 127 A1**

(12) **EUROPEAN PATENT APPLICATION**

(43) Date of publication:
**07.12.2011 Bulletin 2011/49**

(51) Int Cl.:
**H01L 33/00** *(2010.01)*

(21) Application number: **10178692.9**

(22) Date of filing: **23.09.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **02.06.2010 JP 2010126575**

(71) Applicant: **Kabushiki Kaisha Toshiba Tokyo (JP)**

(72) Inventors:
• **Kojima, Akihiro Tokyo (JP)**

• **Sugizaki, Yoshiaki Tokyo (JP)**
• **Obata, Susumu Tokyo (JP)**
• **Nishiuchi, Hideo Tokyo (JP)**

(74) Representative: **HOFFMANN EITLE Patent- und Rechtsanwälte Arabellastraße 4 81925 München (DE)**

(54) **Method for manufacturing light-emitting device**

(57)     According to one embodiment, a method for manufacturing a light-emitting device is disclosed. The method can include forming a first electrode and a second electrode on a semiconductor layer (12) which is included in a first structure body (ST1), the semiconductor layer (12) including a light-emitting layer on a substrate (10). The method can include forming a first metal pillar in conduction with the first electrode, and a second metal pillar in conduction with the second electrode. The method can include filling a region between the first metal pillar and the second metal pillar with an insulating layer. In addition, the method can include separating the substrate (10) from the semiconductor layer (12), and forming a second structure body (ST2) in which the semiconductor layer (12) is supported by the insulating layer and which is convex toward an opposite side of the insulating layer to the semiconductor layer (12).

```
              START

     FORM FIRST STRUCTURE BODY          S110

  FORM FIRST AND SECOND ELECTRODES      S120

 FORM FIRST AND SECOND METAL PILLARS    S130

            FILL RESIN                  S140

    FORM SECOND STRUCTURE BODY          S150

               END
```

FIG. 1

EP 2 393 127 A1

**Description**

<u>FIELD</u>

Embodiments described herein relate generally to a method for manufacturing a light-emitting device.

<u>BACKGROUND</u>

The application of light-emitting devices has been expanding to lighting apparatuses, backlight light sources of image display apparatuses, display apparatuses and the like.

In recent years, a proposal has been made on a method for causing crystal growth of a semiconductor layer, which includes a light-emitting layer therein, on a substrate such as a sapphire substrate. In addition, for the purpose of improving the brightness and reducing the thickness of the light-emitting device, a manufacturing method for separating the substrate from the semiconductor layer by laser light irradiation has been considered as well.

<u>BRIEF DESCRIPTION OF THE DRAWINGS</u>

FIG. 1 is a flow chart describing a method for manufacturing a light-emitting device according to a first embodiment;

FIGS. 2A to 9B are schematic cross-sectional views of the method for manufacturing the light-emitting device according to the first embodiment;

FIGS. 10A and 10B are schematic cross-sectional views illustrating the state where a second structure body is hold by a vacuum chuck;

FIG. 11 is a diagram illustrating a change in the amount of a structure body;

FIGS. 12A and 12B are schematic cross-sectional views describing a n example of another light-emitting device; and

FIGS. 13A to 15B are schematic cross-sectional views of a method for manufacturing a light-emitting device according to a second embodiment.

<u>DETAILED DESCRIPTION</u>

In general, according to one embodiment, a method for manufacturing a light-emitting device is disclosed. The method can include forming a first electrode and a second electrode on a semiconductor layer which is included in a first structure body, the semiconductor layer including a light-emitting layer on a substrate. The method can include forming a first metal pillar in conduction with the first electrode, and a second metal pillar in conduction with the second electrode. The method can include filling a region between the first metal pillar and the second metal pillar with an insulating layer. In addition, the method can include separating the substrate from the semiconductor layer, and forming a second structure body in which the semiconductor layer is supported by the insulating layer and which is convex toward an opposite side of the insulating layer to the semiconductor layer.

Hereinafter, embodiments will be described on the basis of the drawings.

Note that, the drawings are only schematic or conceptual representations, so that the relationship between the thickness and the width of each portion, and the ratio coefficient or the like of the size between portions are not necessarily the same as actual ones. In addition, when some of the drawings represent the same portion, the portion may be represented in a different dimension or ratio coefficient depending on the drawings.

Moreover, throughout the description and the drawings, the same reference numeral is used to denote an element that has been described in a previous drawing, and detailed description of the element is omitted as appropriate.

Here, the aforementioned substrate such as a sapphire substrate has a function not only to cause crystal growth of the semiconductor layer including a light-emitting layer, such as a GaN layer, but also to serve as a structural (mechanical) support body of the light-emitting device. With this taken into consideration, as a technique of separating the substrate from the semiconductor layer, a proposal has been made on a technique in which: a different substrate serving as a support body is temporarily bonded (attached) to the semiconductor layer in advance; and the substrate is subsequently removed therefrom. Use of a different substrate as the support body, however, requires processes including: bonding the different substrate to the semiconductor layer; separating the different substrate that has become unnecessary; and cleansing the bonding surface.

First Embodiment

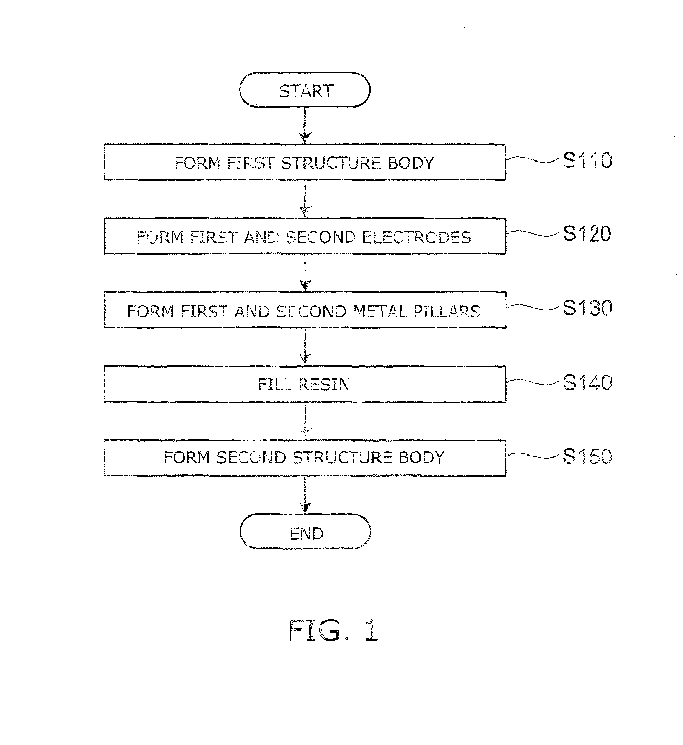

FIG. 1 is a flowchart describing a method for manufacturing a light-emitting device according to a first embodiment.

As shown in FIG. 1, the method for manufacturing a light-emitting device according to the first embodiment includes a process of forming a first structure body (step S110), a process of forming a first electrode and a second electrode (step S120), a process of forming a first metal pillar and a second metal pillar (step S130), a process of filling a region with resin (a insulating layer) (step S140), and a process of forming a second structure body (step S150).

In step S110, the first structure body is formed by stacking a semiconductor layer, which has a light-emitting layer, on a substrate.

In step S120, the first electrode and the second electrode are formed on the semiconductor layer.

In step S130, the first metal pillar in contact with the first electrode and the second metal pillar in contact with the second electrode are formed on the semiconductor layer.

In step S140, a region between the first metal pillar and the second metal pillar is filled with resin.

In step S150, the substrate is separated from the semiconductor layer, as well as thus, the second structure body is formed in which the semiconductor layer is supported by the resin, and convexes toward an opposite side of the resin to the semiconductor layer.

Here, the first structure body is a structure body having a configuration in which a semiconductor layer is stacked on a substrate. The first structure body includes the electrodes and the metal pillars that are formed during the manufacturing process. In addition, the first structure body is configured to include a series of semiconductor layers formed over a broad range of the substrate, or semiconductor layers connected together with an insulator on the substrate during the manufacturing process.

Further, the second structure body has a configuration in which the substrate is separated from the semiconductor layers, and the semiconductor layer is supported by the resin. The second structure body includes a lens or a translucent resin provided as appropriate during the manufacturing process. The lens and translucent resin correspond to a translucent layer.

In the embodiment described above, the semiconductor layer is supported by the resin filled into the region between the metal pillars. Thus, a different substrate for supporting the semiconductor layer when the substrate is separated from the semiconductor layer does not need to be attached to the semiconductor layer. This resin is used as a part of the package of the light-emitting device without being processed.

In addition, a second main surface side is concave. Thus, when the second structure body is held by vacuum suction during the manufacturing process, the second structure body is surely sucked and held while the second main surface side is used as the suction surface. Specifically, during the vacuum suction, a portion around the second main surface comes into close contact with the vacuum suction stage, and air between a center portion of the second main surface and the stage is suctioned with no leakage. Thus, it is made possible to surely hold the second structure body by suction. When surely being sucked and held, the second structure body is corrected to be in a flat state. Thus, the processing to be performed thereafter is accurately performed in this flat state.

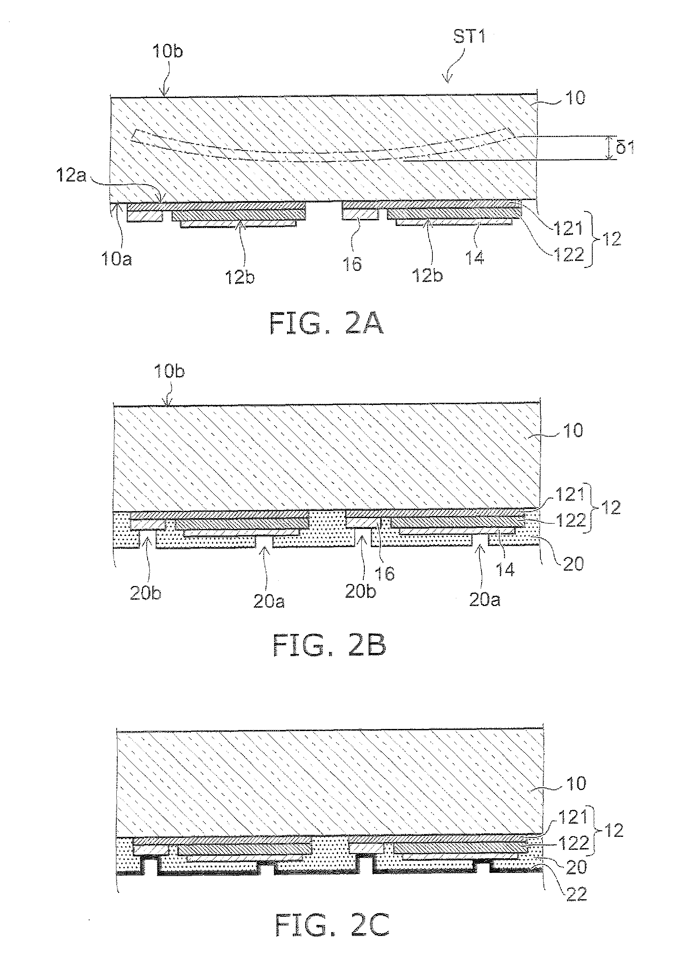

Next, a specific example of the method for manufacturing a light-emitting device will be described in accordance with FIGS. 2A through 9B.

FIGS. 2A through 9B are schematic cross-sectional views sequentially describing the method for manufacturing of a light-emitting device according to this embodiment.

Firstly, as shown in FIG. 2A, a first semiconductor layer 121 and a second semiconductor layer 122 are stacked on a first main surface 10a of a substrate 10. A substrate 10-side surface of the first semiconductor layer 121 corresponds to a first main surface 12a. The second semiconductor layer 122 includes a light-emitting layer (not shown). In a case where the light-emitting layer is formed of a nitride-based semiconductor, for example, it is possible to cause crystal growth of a semiconductor layer 12 on a sapphire substrate, the semiconductor layer 12 configured of the first semiconductor layer 121 and the second semiconductor layer 122. For example, gallium nitride (GaN) is used to form the first semiconductor layer 121 and the second semiconductor layer 122. In addition, for example, a multiple quantum well structure including InGaN is used for the light-emitting layer.

Next, some portions of the second semiconductor layer 122 and the first semiconductor layer 121 are selectively etched away by RIE (Reactive Ion Etching) method using a not-shown resist, for example. Accordingly, recessed portions and protruding portions are formed in a second main surface 12b of the semiconductor layer 12. Parts of the second semiconductor layer 122 and the first semiconductor layer 121, from which the portions have been removed, correspond to the recessed portions, and the remaining portions of the second semiconductor layer 122 including the light-emitting layer correspond to the protruding portions. In addition, portions of the semiconductor layer 12 corresponding to dividing positions used in dicing the structure in a later process are removed until the first main surface 10a of the substrate 10 is exposed. In the manner described above, a first structure body ST1 in which the semiconductor layer 12 is stacked on the substrate 10 is formed.

In the state where the first structure body ST1 is formed, the first structure body ST1 is convex on a side of the surface where the semiconductor layer 12 is formed. Here, in the schematic cross-sectional views used for describing this embodiment, the amount of warpage is presented in a schematic manner as shown by a two-dot chain line in the drawings. The amount of warpage is expressed with a difference $\delta$ between the positions of an edge and a lowermost or uppermost point of a plane (the second main surface 12b, for example) of the structure body. In this embodiment, the amount of warpage by which the structure body is convex toward the second main surface 12b side above which a later described resin 28 is formed is referred to as "positive," while the amount of warpage by which the structure body is convex toward the first main surface 12a side is referred to as "negative."

The amount of warpage in the state where the first structure body ST1 is formed is a positive $\delta 1$. This warpage results from a lattice constant difference, a thermal expansion coefficient difference or the like between the substrate 10 and the semiconductor layer 12 stacked (for example, crystal growth of which is caused) on the substrate 10.

Next, an n-side electrode (the first electrode) 16 in conduction with the first semiconductor layer 121 is formed on each of the recessed portions of the semiconductor layer 12, and a p-side electrode (the second electrode) 14 in conduction with the second semiconductor layer 122 is formed on each of the protruding portions of the semiconductor layer 12. A Ti/Al/Pt/Au laminated film is used to form the n-side electrode 16, for example. A Ni/Al (or Ag)/Au laminated film is used to form the p-side electrode 14, for example.

Next, as shown in FIG. 2B, an insulating film 20 to cover the n-side electrodes 16 and the p-side electrodes 14 is formed. Then, openings (first openings 20a and second openings 20b) are formed in such a way that the n-side electrodes 16 and the p-side electrodes 14 are partially exposed, respectively. Further, as shown in FIG. 2C, a seed metal 22 made of Ti/Cu or the like is formed by a sputtering method, for example.

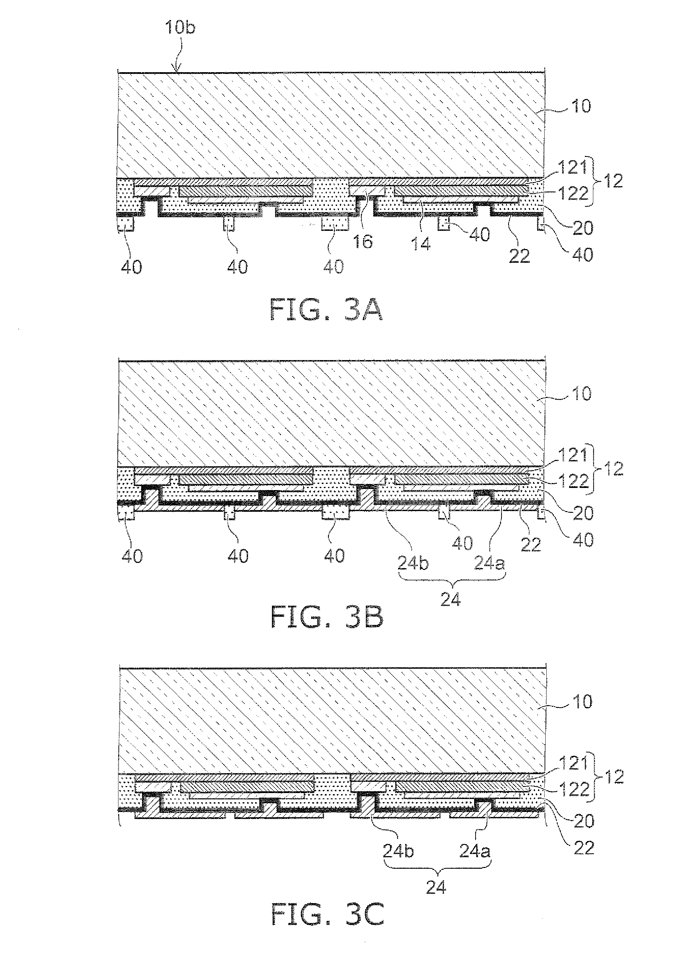

Next, as shown in FIG. 3A, a photoresist 40 is formed and patterned on the seed metal 22. Then, as shown in FIG. 3B, a interconnect layer 24 is selectively formed by electrolytic plating using the patterned photoresist 40 as a mask. In the manner described above, interconnect layers 24a and 24b isolated from each other are formed. During this process, the interconnect layers 24a and 24b are preferably formed in such a way that the bottom areas of the interconnect layers 24a and 24b become larger than the diameters or the bottom areas of the first and second openings 20a and 20b, respectively. In this case, the thin seed metal 22 serves as a current path during the electrolytic plating process. Thereafter, the structure shown in FIG. 3C is obtained when the photoresist 40 is removed by ashing or the like.

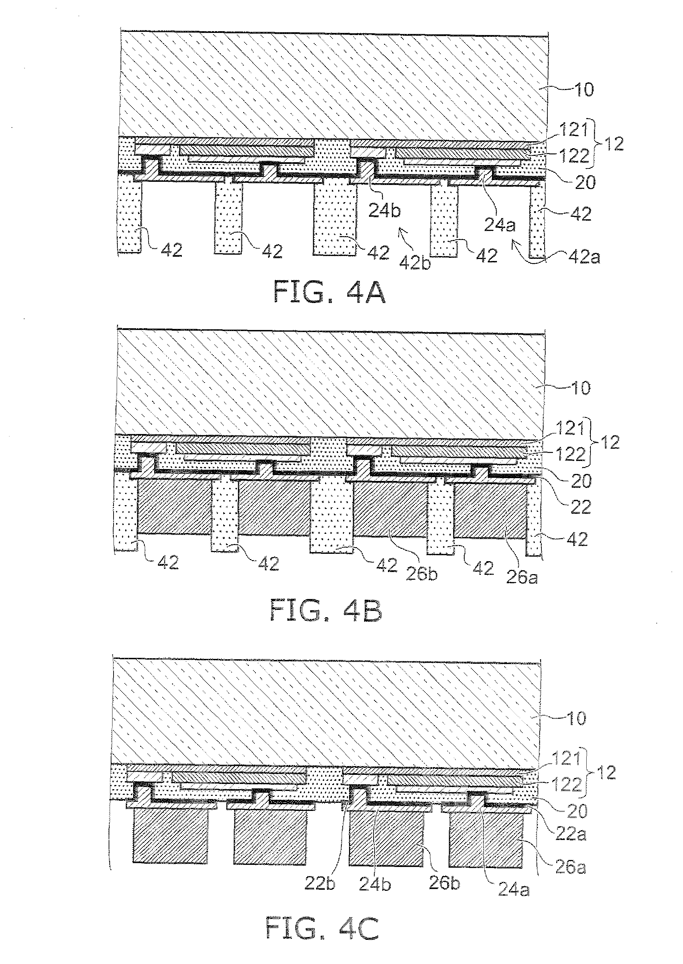

Next, as shown in FIG. 4A, patterning of a thick-film photoresist is performed and then an opening 42a is formed on each of the p-side interconnect layers 24a and an opening 42b is formed on each of the n-side interconnect layers 24b, Subsequently, as shown in FIG. 4B, by use of electrolytic plating, p-side metal pillars (the second metal pillars) 26a connected to the p-side electrodes 14, and n-side metal pillars (the first metal pillars) 26b connected to the n-side electrodes 14 are formed, respectively. In this case as well, the thin seed metal 22 serves as a current path during the electrolytic plating process. Here, when the metal pillars 26 are formed to have a thickness within a range of ten to several hundred μm, the strength of the light-emitting device can be maintained even after the separation of the substrate 10. Note that, the openings 42a and 42b may be formed on an insulating film.

Further, as shown in FIG. 4C, a resist layer 42 is removed by ashing or the like, and the exposed regions of the seed metal 22 are removed by wet-etching, for example, to form a p-side seed metal 22a and an n-side seed metal 22b separated from each other.

Here, copper, gold, nickel, silver or the like is used as a material of the interconnect layers 24 and the metal pillars 26. Among the materials, copper having a good thermal conductivity, a high migration resistance and an excellent property of adhesion with an insulating film is more preferable.

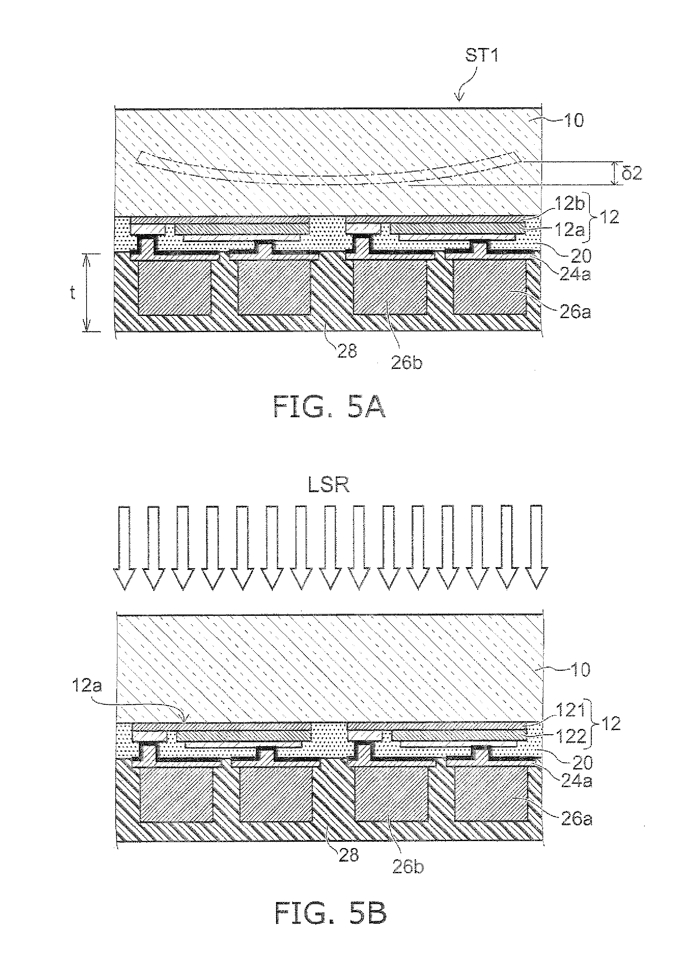

Subsequently, as shown in FIG. 5A, the region between the metal pillars 26a and 26b is filled with a resin 28. A thermosetting epoxy resin, silicone resin, or fluororesin is used as the resin 28, for example. The resin 28 is colored black, for example, and prevents leakage of light to the outside and entrance of unnecessary light from the outside.

The first structure body ST1 is convex toward the second main surface 12b side in the state where the resin 28 is formed. A positive amount of warpage δ2 is smaller than the amount of warpage δ1 before the resin 28 is formed. This is because the amount of warpage δ1 of the first structure body ST1 changes due to a stress caused by the resin 28. In this embodiment, the amount of warpage δ2 is set by formation of the resin 28. Specifically, in this embodiment, when the resin 28 is formed, the amount of warpage δ2 of the first structure body ST1 is set in such a way that the amount of warpage of a later-described second structure body ST2 causes the second structure body ST2 to be convex toward the first main surface 12a side.

The setting of the amount of warpage δ2 of the first structure body ST1 by the resin 28 can be achieved, for example, by use of a thickness of the resin 28; a property of the material of the resin 28 such as a linear expansion coefficient or a shaping shrinkage ratio; and shaping conditions of the resin 28. In the example shown in FIG. 5A, the amount of warpage δ2 of the first structure body ST1 is set by use of a thickness t of the resin 28. As shown in FIG. 5A, the resin 28 is formed to a depth to cover the lower ends of the metal pillars 26a and 26b.

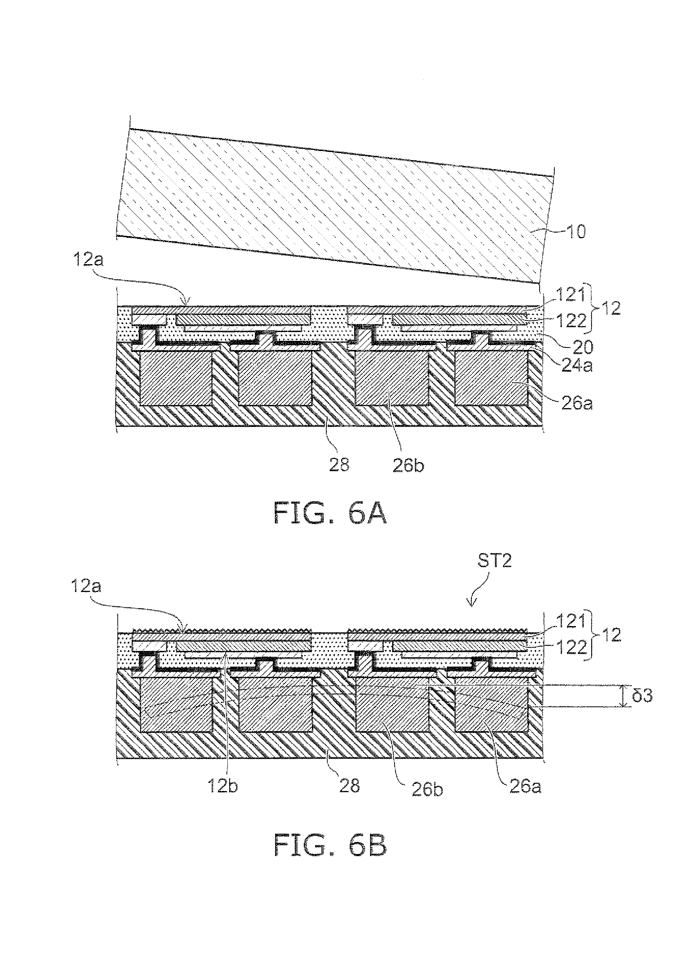

Next, as shown in FIGS. 5B and 6A, a laser lift-off (LLO) process is performed to separate the substrate 10 from the first main surface 12a of the semiconductor layer 12. As a laser light LSR, an ArF laser (wavelength: 193 nm), a KrF laser (wavelength: 248 nm), a XeCl laser (wavelength: 308 nm), or an XeF laser (wavelength: 353 nm) is used, for example.

The laser light LSR is irradiated on the substrate 10 from a side of a second main surface 10b of the substrate 10 toward the semiconductor layer 12. The laser light LSR is transmitted through the substrate 10, and then reaches the bottom surface (the main surface 12a) of the semiconductor layer 12. At this time, the semiconductor layer 12 absorbs the energy of the laser light LSR at the interface between the substrate 10 and the semiconductor layer 12. Then, a GaN component in the semiconductor layer 12 is thermally dissolved as shown in the following reaction formula.

$$GaN \rightarrow Ga + (1/2) N_2 \uparrow$$

As a result, as shown in FIG. 6A, the substrate 10 is separated from the semiconductor layer 12.

When the laser lift-off process is performed, if the resin 28 is formed with a sufficiently large thickness, a support substrate (not shown) becomes unnecessary during the laser irradiation. If the resin 28 covers the lower ends of the metal pillars 26a and 26b and has a thickness of approximately 60 $\mu$m to 1 mm, the support substrate becomes unnecessary during the laser irradiation.

After the separation of the substrate 10, the second structure body ST2 is formed as shown in FIG. 6B. The semiconductor layer 12 remaining after the separation of the substrate 10 is supported by the resin 28 in the second structure body ST2. In this state, the second structure body ST2 is convex toward the first main surface 12a side. The amount of warpage $\delta 3$ of the second structure body ST2 is set by the resin 28 formed previously. Note that, a frost process is performed on the surface 12a from which the substrate 10 is separated, depending on the necessity.

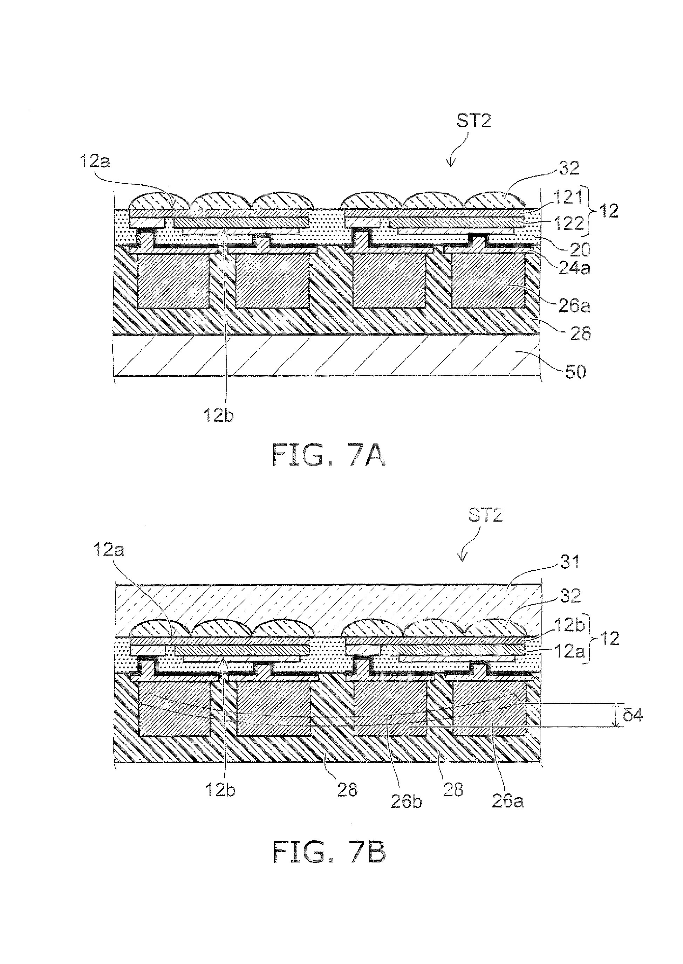

Next, as shown in FIG. 7A, the surface of the resin 28 of the second structure body ST2 is held by a vacuum chuck 50. The second structure body ST2 is convex toward the first main surface 12a side because of the previous processes. Accordingly, when suction is performed on the second main surface 12b (the surface of the resin 28 of the second structure body ST2) by the vacuum chuck 50, the suction is surely performed with no air leakage.

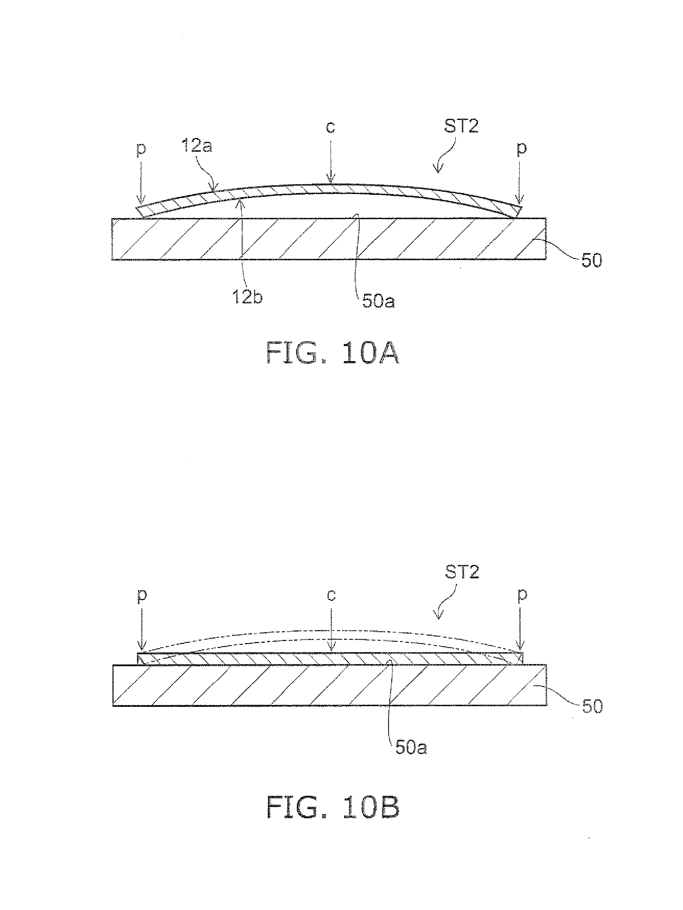

FIGS. 10A and 10B are schematic cross-sectional views illustrating the state where the second structure body is held by the vacuum chuck.

As shown in FIG. 10A, the second structure body ST2 is convex toward the first main surface 12a side. When the second structure body ST2 is placed on a stage surface 50a of the vacuum chuck 50 in this state, peripheral portions p of the bottom surface (the second main surface 12b-side surface) of the second structure body ST2 come in contact with the stage surface 50a.

When vacuum suction is performed by the vacuum chuck 50 in this state, the peripheral portions p of the bottom surface of the second structure body ST2 come in close contact with the stage surface 50a, and air existing between a center portion c of the bottom surface of the second structure body ST2 and the stage surface 50a is suctioned without any leakage. As a result, as shown in FIG. 10B, the second structure body ST2 comes in close contact with the stage surface 50a of the vacuum chuck 50, and is thus held in a flat state. As described above, when the concave surface is sucked by a vacuum chuck, the structure body is surely held.

As shown in FIG. 7A, lenses 32 are formed on the first main surface 12a of the semiconductor layer 12, depending on the necessity, in the state where the second structure body ST2 is sucked and held by the vacuum chuck 50. The formation of the lenses 32 is achieved by: forming a dot pattern on a silica glass by use of a photoresist; subsequently performing isotropic etching using a wet-etching method; and thereby forming the lens shapes. Here, a nanoimprinting technique can be used as well. In a nanoimprinting technique, the semiconductor layer 12 is coated with a liquid SOG (spin on glass) having a property of turning into glass when heated, a silicone resin or the like by spin coating or the like; and then, a nanostamper with the lens shapes is pressed against the resultant semiconductor layer 12 to form the lens shape; thereafter, the nanostamper is separated from the semiconductor layer 12; and the SOG or silicone resin is cured by heating. This technique enables the shape of the nanostamper to be optionally designed. Thus, any shape of lens can be easily fabricated.

Moreover, as shown in FIG. 7B, a translucent resin 31 is formed on the first main surface 12a. In a case where the wavelength of light produced in the light-emitting layer is converted and then outputted from the light-emitting device, for example, the translucent resin 31 in which phosphors (not shown) are mixed is provided. In a case where blue light is produced in the light-emitting layer and then white light is to be outputted from the light-emitting device, for example, the translucent resin 31 in which yellow phosphors are mixed is formed. Thereafter, when the second structure body ST2 is released from the vacuum chuck 50, the second structure body ST2 is convex from the first main surface 12a side toward the second main surface 12b side as shown in FIG. 7B. This is because the amount of warpage changes when the translucent resin 31 is formed on the first main surface 12a. The amount of warpage in this state is a positive $\delta 4$.

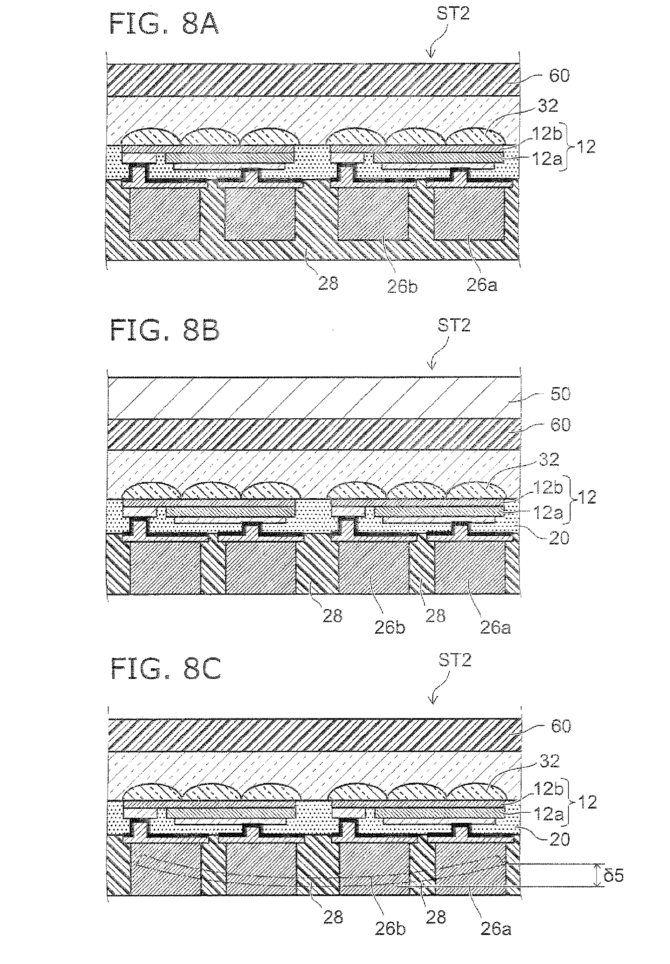

Next, as shown in FIG. 8A, a back grind tape 60 is attached to the surface of the translucent resin 31. Thereafter, as shown in FIG. 8B, vacuum suction is performed on the surface of the back grind tape 60 by the vacuum chuck 50. Here, the second structure body ST2 is convex from the first main surface 12a side toward the second main surface 12b side, that is, the second structure body ST2 is concave from the second main surface 12b side toward the first main surface 12a side, because of the previous processes (refer to FIG. 8A). Accordingly, the suction and holding of the surface of the back grind tape 60 by the vacuum chuck is achieved by sucking the concave surface by the vacuum chuck 50. Thus, the vacuum suction is surely performed without any air leakage as illustrated in FIGS. 10A and 10B. When being sucked and held by the vacuum chuck 50, the second structure body ST2 is corrected into a flat state.

As shown in FIG. 8B, while the second structure body ST2 is held by the vacuum chuck 50 and thus corrected in a flat state, the surface of the resin 28 is ground. The metal pillars 26a and 26b are exposed from the surface of the resin 28 by this grinding process.

As shown in FIG. 8C, when the second structure body ST2 is released from the vacuum chuck 50 after the grinding of the resin 28, the amount of warpage of the second structure body ST2 changes from the positive $\delta 4$ to a positive $\delta 5$. This is because the stress caused by the resin 28 changes when the resin 28 is ground and thus becomes thinner. Accordingly, the positive amount of warpage $\delta 5$ is larger than the positive amount warpage $\delta 4$.

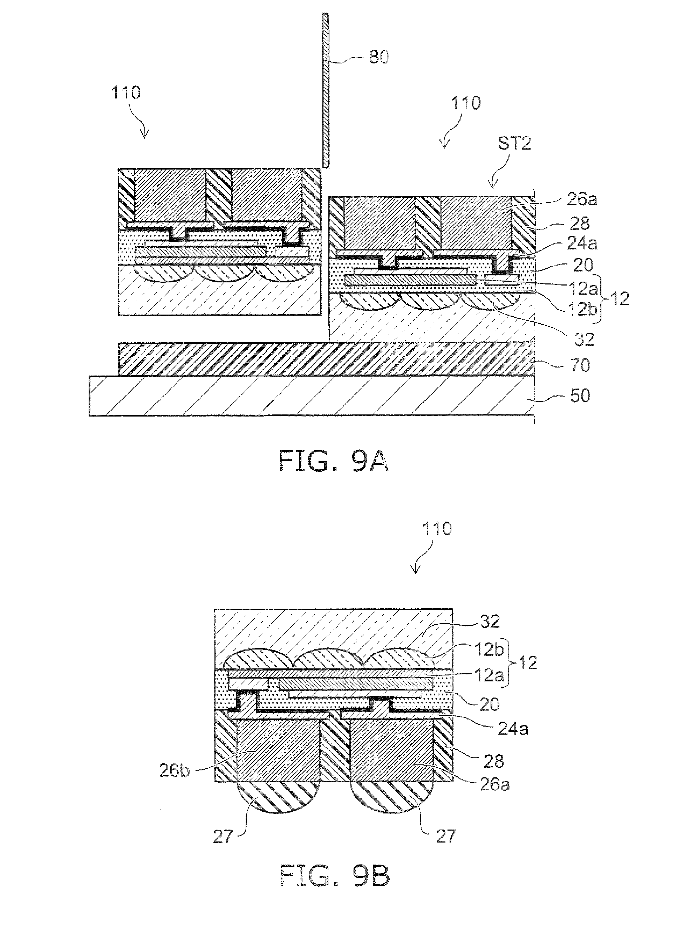

Next, the back grind tape 60 is peeled off, and then, a dicing tape 70 is attached to the surface as shown in FIG. 9A. Note that, FIG. 9A shows a state where the state shown in FIG. 8 is inverted (upside down). Then, the resin 28, the insulating film 20 and the translucent resin 31 are cut along a dicing line by use of a blade 80. With this process, the second structure body ST2 is diced into individuals. Note that, as another dicing method, a method such as cutting by laser irradiation or high-pressure water is used instead of the mechanical cutting by use of the blade 80 such as a diamond blade.

When this dicing is performed, the surface of the dicing tape 70 is sucked and held by the vacuum chuck 50. Here, the second structure body ST2 is concave toward the dicing tape 70 side. For this reason, when the concave surface is sucked by the vacuum chuck 50, the second structure body ST2 is surely sucked and held with no air leakage as illustrated in FIGS. 10A and 10B. Since the second structure body ST2 is sucked and held by the vacuum chuck, the second structure body ST2 is accurately diced in a flat state.

Thereafter, each individual light-emitting device 110 is removed from the dicing tape 70, and bump electrodes 27 are formed respectively on the metal pillars 26a and 26b exposed from the resin 28, as illustrated in FIG. 9B. Solder balls or metal bumps are used as the bump electrodes 27, respectively, for example. Accordingly, the light-emitting device 110 is completed.

With the method for manufacturing a light-emitting device according to this embodiment described above, a chip size package (CSP) obtained by reducing the size of the light-emitting device 110 almost to such a small bare chip size can be easily provided because the light-emitting device 110 is assembled at a wafer level.

In addition, since the semiconductor layer 12 is supported by the resin 28 filled in the region on the second main surface 12b, a different substrate for supporting the semiconductor layer 12 when the substrate 10 is separated from the semiconductor layer 12 does not have to be attached to the semiconductor layer 12. This resin 28 is used as a part of the package of the light-emitting device 110 without being processed.

Moreover, when the first structure body ST1 or the second structure body ST2 is sucked and held by the vacuum chuck 50 during the manufacturing process, a concave side is sucked. Thus, the first structure body ST1 or the second structure body ST2 is surely sucked and held. In this manner, processing is performed in a state where the first structure body ST1, or the second structure body ST2 is made flat. Thus, the processing is surely performed. Accordingly, without complicating the manufacturing processes, an improvement in the volume productivity of the light-emitting devices 110 is achieved.

Next, a specific example of the method for manufacturing a light-emitting device according to this embodiment will be described.

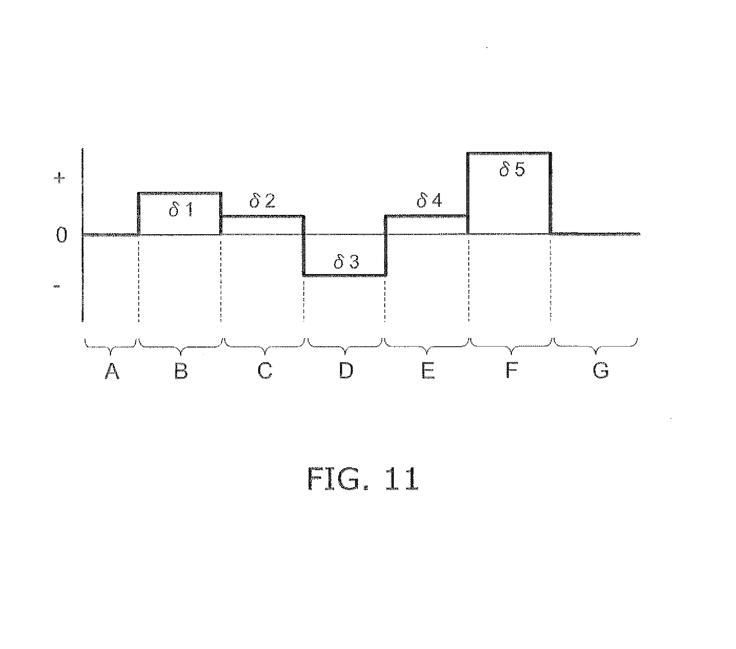

FIG. 11 is a diagram illustrating change in the amount of warpage of a structure body according to the specific example.

In FIG. 11, the horizontal axis shows the flow (time) of manufacturing processes A through J, while the vertical axis shows the amount of warpage of the substrate and the structure body.

The specific example will be described with a case where: a sapphire substrate is used as the substrate 10; and a GaN layer is used as the semiconductor layer 12. Moreover, the first semiconductor layer 121 is formed as the n-type semiconductor layer, and the second semiconductor layer 122 is formed as the p-type semiconductor layer.

Firstly, a sapphire substrate is prepared in a manufacturing process A. The sapphire substrate can be processed in a way that the amount of warpage is approximately equal to zero by grinding the both surfaces thereof. The amount of warpage is thus approximately zero in the manufacturing process A. Even if a warpage occurs on the sapphire substrate, the absolute value of a later-described amount of warpage is smaller than $\delta2$.

Next, in a manufacturing process B, the semiconductor layer 12, which is the GaN layer including a light-emitting layer, is formed on the sapphire substrate to form a first structure body ST1. Then, an n-side electrode 16 is formed on a first semiconductor layer 121, and a p-side electrode 14 is formed on a second semiconductor layer 122. The first structure body ST1 is convex toward the second main surface 12b side (positive) by the amount of warpage $\delta1$. The amount of warpage $\delta1$ is approximately 50 micrometer ($\mu$m) in the case of a two-inch sapphire substrate, approximately 75 $\mu$m in the case of a four-inch sapphire substrate and approximately 100 $\mu$m in the case of a six-inch sapphire substrate, for example.

Next, interconnect layers 24a and 24b are formed on the p-side and n-side electrodes 14 and 16, respectively. Metal pillars 26a and 26b are further formed on the interconnect layers, respectively. Copper is used to form the interconnect layers 24 and metal pillars 26. In this process, in order for the sapphire substrate located on the concave side to be sucked and held by a vacuum chuck, the first structure body ST1 is held and processed in such a way that the amount of warpage becomes equal to approximately zero.

Next, in a manufacturing process C, a process of filling the region between the metal pillars 26a and 26b with resin 28 is performed. A thermosetting epoxy resin is used for the resin 28. In a state where the region is filled with the resin 28 by the manufacturing process C, the amount of warpage of the first structure body ST1 becomes $\delta2$. The first structure body ST1 is convex toward the second main surface 12b side. The amount of warpage $\delta2$ is positive, and smaller than the amount of warpage $\delta1$. Here, the amount of warpage $\delta2$ is set by selection of the thickness or a property of the material (linear expansion coefficient or shaping shrinkage ratio, for example) of the resin 28 or selection of shaping conditions of the resin 28. This set amount is that which causes the amount of warpage δ3 of the second structure body ST2 after the sapphire substrate is separated in a later process to become negative. The second structure body ST2 is concave toward the second main surface 12b side. In this specific example, the resin 28 having a thickness of 350 μm is formed on the first main surface 10a-side of the sapphire substrate, first; and then, the thickness of the resin 28 is reduced to 300 μm by a grinding process, for example. In this specific example, the linear expansion coefficient of the resin 28 is $62 \times 10^{-6}$/K for example. Accordingly, the amount of warpage δ2 becomes approximately smaller than 10 μm in the case of the two-inch sapphire substrate, approximately smaller than 15 μm in the case of the four-inch sapphire substrate, and approximately smaller than 20 μm in the case of the six-inch sapphire substrate.

Next, in a manufacturing process D, the sapphire substrate is separated from the semiconductor layer 12 by a laser lift off process using an excimer laser. Ga precipitated on the first main surface 12a of the semiconductor layer 12 is removed by dilute hydrofluoric acid treatment. When the sapphire substrate is separated, the remaining semiconductor layer 12 is supported by the resin 28. Here, the second structure body ST2 including this semiconductor layer 12 and the resin 28 is convex toward the first main surface 12a side. The amount of warpage of the second structure body ST2 becomes δ3 being negative. The amount of warpage 53 is smaller than approximately 50 μm in the case of the two-inch sapphire substrate, smaller than approximately 75 μm in the case of the four-inch sapphire substrate, and smaller than approximately 100 μm in the case of the six-inch sapphire substrate, for example. Note that, as described earlier, the amount of warpage δ3 is set by the thickness or the property of the material of the resin 28.

Note that, instead of the laser lift off process, a chemical lift off process or chemical mechanical polishing (CMP) process may be used to remove the sapphire substrate from the semiconductor layer 12, for example. In this case, as well, the amount of warpage δ3 of the second structure body ST2 after the removal of the sapphire substrate becomes approximately equal to the value obtained when a laser lift off process is used.

The absolute value of the amount of warpage δ3 becomes larger than the absolute value of the amount of warpage 52. In addition, the absolute value of the amount of warpage δ3 becomes smaller than the absolute value of the amount of warpage δ1.

Next, lenses 32 and a translucent resin 31 are formed. In this process, for example, since the second structure body ST2 is sucked and held by a vacuum chuck, the processing is performed in a state where the second structure body is held while the amount of warpage is approximately equal to zero. In order to form a lens layer, for example, application of a silicone resin with a thickness of approximately 200 μm is performed, and a lens pattern is formed by an imprinting method. A material having a linear expansion coefficient of $290 \times$ $10^{-6}$/K is used for the silicone resin. When the lens layer is formed, the lenses 32 are formed at the accurate positions because the second structure body ST2 is made flat, Specifically, ±5 μm matching accuracy of the nanostamper is achieved by performing an imprinting process in parallel with the second structure body ST2.

Next, the translucent resin 31 containing phosphors is formed on the lenses 32. A material obtained by dispersing phosphor particles into a phenyl resin is used for the translucent resin 31. This material is formed with a thickness of approximately 200 μm by vacuum printing.

Next, in a manufacturing process E, the second structure body ST2 after the translucent resin 31 is formed therein is convex toward the second main surface 12b side by the amount of warpage δ4 being positive. The amount of warpage 54 is smaller than approximately 10 μm in the case of the two-inch sapphire substrate, smaller than approximately 15 μm in the case of the four-inch sapphire substrate, and smaller than 20 μm in the case of the six-inch sapphire substrate.

In FIG. 11, the amount of warpage δ4 is approximately equal to the amount of warpage δ2. Here, the amount of warpage δ2 is preferably small from the standpoint that the substrate 10 is to be removed. For this reason, the amount of warpage δ2 is smaller than the amount of warpage δ4.

Next, the resin 28 is ground. In this process, the back grind tape 60 is attached to the translucent resin 31, and is sucked and held by a vacuum chuck. The surface to which the back grind tape 60 is attached is concave. For this reason, when being sucked and held by the vacuum chuck, the second structure body ST2 is held in such a way that the amount of warpage of the second structure body ST2 becomes approximately equal to zero. In this state, the resin 28 is ground until the metal pillars 26a and 26b are exposed.

Next, in a manufacturing process F, after the grinding of the resin 28, the second structure body ST2 released from the vacuum chuck is convex toward the second main surface 12b side by the amount of warpage δ5 being positive. The amount of warpage δ5 is smaller than approximately 100 μm in the case of the two-inch sapphire substrate, smaller than approximately 150 μm in the case of the four-inch sapphire substrate, and smaller than approximately 200 μm within the case of the six-inch sapphire substrate, for example.

The amount of warpage δ5 is larger than the amounts of warpage δ1, δ2, or δ4. In addition, the absolute value of the amount of warpage δ5 is larger than the absolute value of the amount of warpage δ3.

Next, in a manufacturing process G, the second structure body ST2 is diced into individuals. In this manufacturing process G, the back grind tape 60 is replaced by a dicing tape 70, and the surface side to which the dicing tape 70 is attached is sucked and held by a vacuum chuck. Since the surface to which the dicing tape 70 is attached is concave, the second structure body ST2 is held by the vacuum chuck in such a way that the amount of warpage of the second structure body ST2 becomes equal to approximately zero. In this state, the structure is cut from the resin 28 along a dicing line to form individuals. Since the amount of warpage is zero, the blade can be accurately and surely inserted to perform the dicing process.

In any of the manufacturing processes, the maximum value of the amount of the warpage of the structure body is not greater than the maximum amount of warpage that the vacuum chuck 50 can hold.

In addition, the manufacturing process C and the following processes are performed at a temperature lower than a processing temperature of an activation process of the semiconductor layer 12 performed in the manufacturing process B.

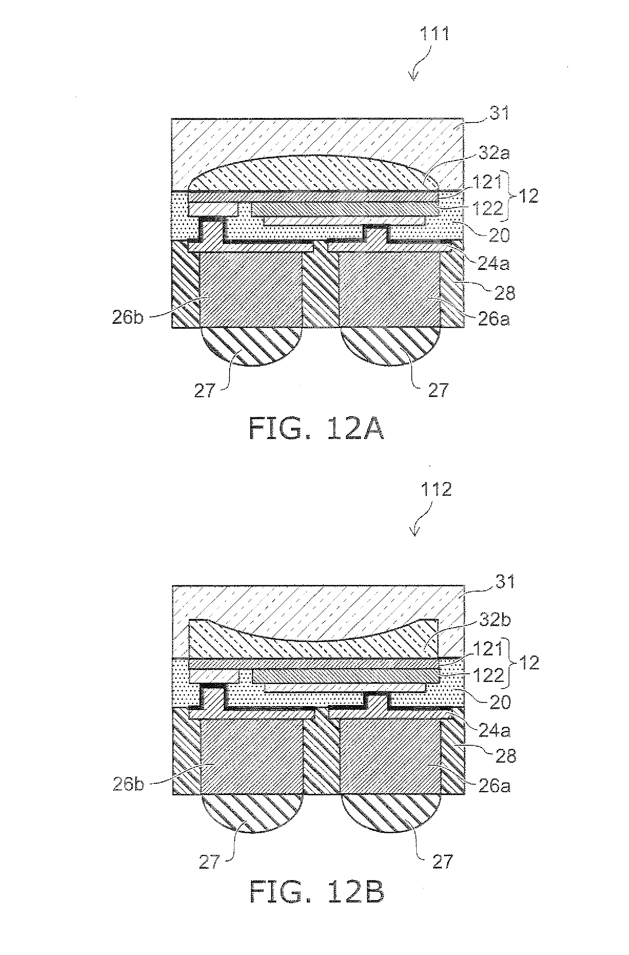

> FIGS. 12A and 12B are schematic cross-sectional views describing an example of another light-emitting device.
> FIG. 12A shows an example of a light-emitting device 111 in which a single lens 32a is provided on a semiconductor layer 12. FIG. 12B shows an example of a light-emitting device

112 including a lens 32b which is a concave lens.

As illustrated in FIG. 12A, a single lens 32a is provided on an individualized unit of the semiconductor layer 12 in the light-emitting device 111. Note that, a required number of lenses are provided in a required arrangement.

As illustrated in FIG. 12B, the concave lens 32b is provided in the light-emitting device 112. Instead of the concave shape, various lens shapes including an aspheric surface and the like can be used.

Second Embodiment

Next, a method for manufacturing a light-emitting device according to a second embodiment will be described.

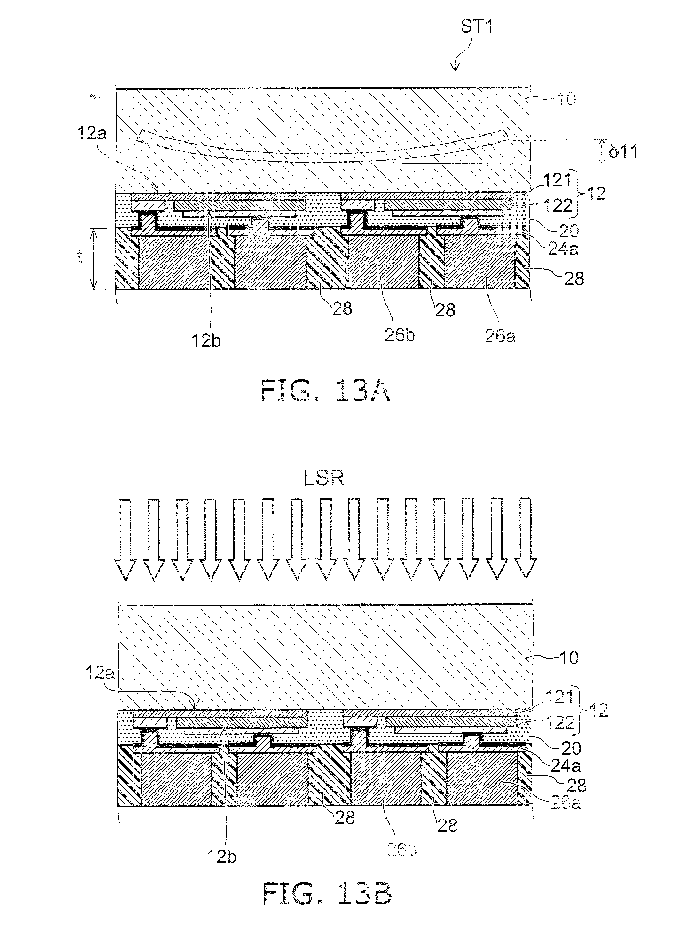

FIGS. 13A through 15B are schematic cross-sectional views sequentially illustrating the method for manufacturing a light-emitting device according to the second embodiment.

The method for manufacturing a light-emitting device according to the second embodiment is a manufacturing method used in a case where no translucent resin 31 is provided on the first main surface 12a of the semiconductor layer 12.

FIG. 13A illustrates a state where the region between the metal pillars 26a and 26b is filled with the resin 28. In the second embodiment, a thickness t of the resin 28 is set substantially equal to the height of each of the metal pillars 26a and 26b. Here, the amount of warpage $\delta 11$ of the first structure body ST1 is set by the resin 28. Specifically, when the resin 28 is formed, the amount of warpage $\delta 11$ of the first structure body ST1 is set in such a way that the second structure body ST2 becomes convex toward the first main surface 12a side by a later-described amount of warpage $\delta 12$. The amount of warpage $\delta 11$ is set by selection of the thickness or a property of the material (linear expansion coefficient or shaping shrinkage ratio, for example) of the resin 28, by selection of shaping conditions of the resin 28, or by the volume of the resin 28. In a case where the amount of warpage $\delta 11$ is set by the volume of the resin 28, the volume of the region to be filled with the resin 28 may be previously set by the height of the metal pillars 26a and 26b as well as the distance therebetween.

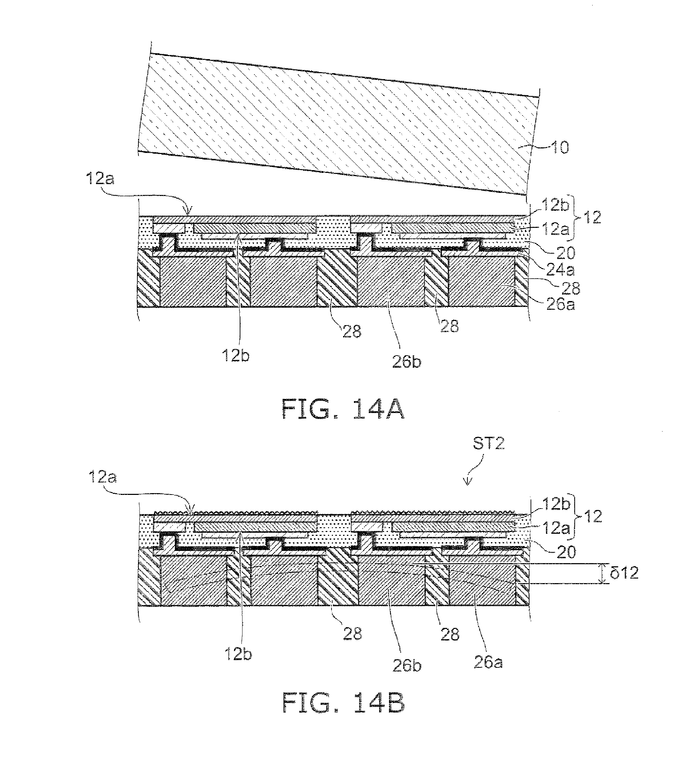

Next, as shown in FIGS. 13B and 14A, a laser lift off process is performed to separate the substrate 10 from the first main surface 12a of the semiconductor layer 12. After the separation of the substrate 10, the second structure body ST2 is formed as shown in FIG. 14B. Here, the semiconductor layer 12 remaining after the separation of the substrate 10 is supported by the resin 28 in the second structure body ST2. In this state, the second structure body ST2 is convex toward the first main surface 12a side. The amount of negative warpage $\delta 12$ is set by the resin 28 previously formed.

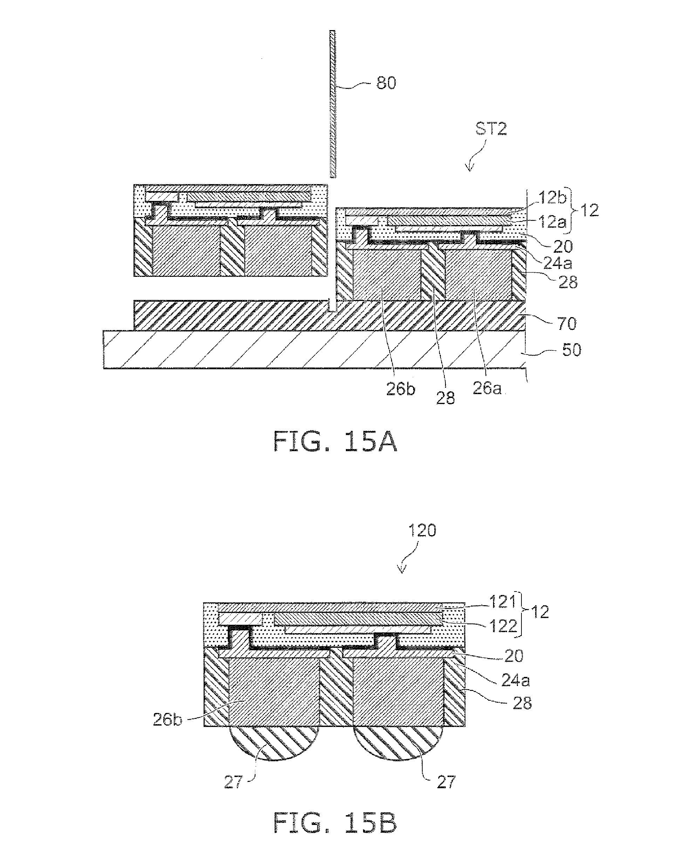

Next, as shown in FIG. 15A, a dicing tape 70 is attached to the surface of the resin 28. Then, the surface of the dicing tape 70 is sucked and held by a vacuum chuck 50. Since the second structure body ST2 is concave toward the dicing surface 70 side, the second structure body ST2 is surely sucked and held without any air leakage by sucking the concave surface with the vacuum chuck 50. Then, a dicing process is performed by use of a blade 80 from the main surface 12a along a dicing line to cut the insulating film 20 and the resin 28. Here, since the second structure body ST2 is sucked and held by the vacuum chuck 50, the second structure body ST2 is made flat. Thus, the second structure body ST2 is precisely cut into individuals during the dicing process, thus. In this manner, a light-emitting device 120 is completed as shown in FIG. 15B.

As described above, according to the method for manufacturing a light-emitting device according to this embodiment, the following advantageous effects will be brought about.

Specifically, when a light-emitting device is manufactured by a method of stacking a semiconductor layer on a substrate, an additional support substrate which would otherwise be prepared when the substrate is separated from the semiconductor layer does not have to be prepared. Thus, the processes including preparation of the additional support substrate, separation of the additional support substrate and cleansing of the separation surface are no longer required.

In addition, the process of attaching the additional substrate to the semiconductor layer by an adhesive agent is not involved, so that problems including damage (crack or the like) on the semiconductor layer, which results from correction of warpage when the additional substrate is attached thereto, and the delamination of the support substrate do not occur.

In addition, when the substrate is removed by a laser lift off process or the like, a sufficient amount of depth of focus for laser light irradiation can be secured over the entire substrate by setting the amount of warpage of the substrate. Accordingly, it is made possible to precisely separate the substrate.

As a result of the above, a method for manufacturing a light-emitting device, which is excellent in volume productivity, is provided without complicating the manufacturing processes.

Light-emitting devices manufactured in accordance with this embodiment are applied to various electronic apparatuses such as lighting apparatuses, backlight sources of image display apparatuses and display apparatuses.

Hereinabove, the certain embodiments have been described with reference being made to the specific examples. Embodiments of the invention are not limited to the certain embodiments, however. The scope of the invention includes, for example, any embodiment which is obtained when a person skilled in the art adds or deletes a constituent element or changes the design of a constituent element with respect to each of the aforementioned embodiments or a variation thereof depending on the necessity, and any embodiment which is obtained when a person skilled in the art combines characteristic features of the aforementioned embodiments depending on the necessity as long as such embodiments have the gist of the invention. In addition, any embodiment in which a person skilled in the art applies various design changes to the material, size, shape layout or the like of the substrate, semiconductor layer, electrodes, interconnections, metal pillars, insulating film or resin is also included in the scope of the invention unless such an embodiment departs from the gist of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

**Claims**

1.  A manufacturing method of a light-emitting device, comprising:

    forming a first electrode and a second electrode on a semiconductor layer (12) which is included in a first structure body (ST1), the semiconductor layer (12) including a light-emitting layer on a substrate (10);

    forming a first metal pillar in conduction with the first electrode, and a second metal pillar in conduction with the second electrode;

    filling a region between the first metal pillar and the second metal pillar with an insulating layer; and

    separating the substrate (10) from the semiconductor layer (12), and forming a second structure body (ST2) in which the semiconductor layer (12) is supported by the insulating layer and which is convex toward an opposite side of the insulating layer to the semiconductor layer (12).

2.  The method according to claim 1, wherein the first structure body (ST1) is convex toward a side where the semiconductor layer (12) is formed on the substrate (10) by a first amount of warpage.

3.  The method according to claim 2, wherein the first structure body (ST1) is convex toward the opposite side of the insulating layer to the semiconductor layer (12) by a second amount of warpage smaller than the first amount of warpage after the filling of the region with the insulating layer.

4.  The method according to any of claims 1-3, wherein the second structure body (ST2) is convex toward the opposite side of the insulating layer to the semiconductor layer (12) by a third amount of warpage after the separating of the substrate (10) from the semiconductor layer (12).

5.  The method according to claim 4, wherein the third amount of warpage has an absolute value larger than an absolute value of the second amount of warpage.

6.  The method according to any of claims 1-5, wherein, a surface of the semiconductor layer (12) is irradiated with a laser light (LSR) through the substrate (10) in the separating of the substrate (10) from the semiconductor layer (12), the surface being bonded to the substrate (10).

7.  The method according to any of claims 1-6, wherein the second structure body (ST2) is convex toward a side of the insulating layer to the semiconductor layer (12) after the insulating layer is filled into the region in the filling of the region with the insulating layer.

8.  The method according to any of claims 1-7, further comprising, forming a translucent layer on the semiconductor layer (12) in a state where the insulating layer is held by suction from the opposite side of the insulating layer to the semiconductor layer (12) after the separating the substrate (10) from the semiconductor layer (12).

9.  The method according to any of claims 1-8, further comprising, forming a translucent layer covering the semiconductor layer (12) in a state where the insulating layer is held by suction from the opposite side of the insulating layer to the semiconductor layer (12) after the separating the substrate (10) from the semiconductor layer (12).

10. The method according to claim 9, wherein the second structure body (ST2) is convex toward the opposite side of the insulating layer to the semiconductor layer (12) by a fourth amount of warpage after the forming the translucent layer.

11. The method according to claim 10, further comprising making the insulating layer after filling the region with the insulating layer and before separating the substrate (10), wherein the second structure body (ST2) is convex toward the opposite side of the insulating layer to the semiconductor layer (12) by a fifth amount of warpage larger than the fourth amount of warpage after the insulating layer is made flat.

12. The method according to claim 9, wherein the second structure body (ST2) is convex toward the opposite side of the insulating layer to the semiconductor layer (12) after the translucent layer is formed and the suction used to hold the insulating layer is released.

13. The method according to any of claims 1-12, further comprising, holding the insulating layer by suction from an opposite side of the second structure body (ST2) to the insulating layer, making the insulating layer flat, and exposing at least one of the first metal pillar and the second metal pillar after the forming the insulating layer.

14. The method according to claim 12, further comprising, holding the translucent layer by suction from a side of the translucent layer to the second structure body (12), making the insulating layer flat, and exposing at least one of the first metal pillar and the second metal pillar after the forming the translucent layer.

15. The method according to any of claims 1-14, wherein the first structure body (ST1) has a first amount of warpage, and is convex toward a side where the semiconductor layer (12) is formed on the substrate (10), and the first structure body (ST1) has a second amount of warpage smaller than the first amount of warpage, and is convex toward the opposite side of the insulating layer to the semiconductor layer (12) after the filling the region with the insulating layer.

16. The method according to claim 14, wherein the second structure body (ST2) has a fourth amount of warpage, and is convex toward the opposite side of the insulating layer to the semiconductor layer (12) after the forming the translucent layer, and the second structure body (ST2) has a fifth amount of warpage larger than the fourth amount of warpage, and is convex toward the opposite side of the insulating layer to the semiconductor layer (12) after the insulating layer is made flat.

17. The method according to claim 14, further comprising making the insulating layer after filling the region with the insulating layer and before separating the substrate (10), wherein the first structure body (ST1) is convex toward a side where the semiconductor layer (12) is formed on the substrate (10) by a first amount of warpage, the first structure body (ST1) is convex toward the opposite side of the insulating layer to the semiconductor layer (12) by a second amount of warpage smaller than the first amount warpage after the filling the region with the insulating layer, the second structure body (ST2) is convex toward the opposite side of the insulating layer to the semiconductor layer (12) by a third amount of warpage after the separating the substrate (10) from the semiconductor layer (12), the second structure body (ST2) is convex toward the opposite side of the insulating layer to the semiconductor layer (12) by a fourth amount of warpage after the forming the translucent layer, and the second structure body (ST2) is convex toward the opposite side of the insulating layer to the semiconductor layer (12) by a fifth amount of warpage larger than the fourth amount of warpage after the insulating layer is made flat.

18. The method according to any of claims 1-17, wherein an amount of warpage by which the second structure body (ST2) is convex is set by one or more of

- a thickness of the insulating layer,
- a material property of the insulating layer, and
- a linear expansion coefficient of the insulating layer.

19. A light-emitting device manufacturable according to a method according to one of claims 1 to 18.

START

FORM FIRST STRUCTURE BODY — S110

FORM FIRST AND SECOND ELECTRODES — S120

FORM FIRST AND SECOND METAL PILLARS — S130

FILL RESIN — S140

FORM SECOND STRUCTURE BODY — S150

END

FIG. 1

FIG. 2A

FIG. 2B

FIG. 2C

FIG. 3A

FIG. 3B

FIG. 3C

**FIG. 4A**

**FIG. 4B**

**FIG. 4C**

EP 2 393 127 A1

FIG. 5A

FIG. 5B

FIG. 6A

FIG. 6B

FIG. 7A

FIG. 7B

FIG. 8A

FIG. 8B

FIG. 8C

FIG. 9A

FIG. 9B

FIG. 10A

FIG. 10B

FIG. 11

EP 2 393 127 A1

FIG. 12A

FIG. 12B

FIG. 13A

FIG. 13B

FIG. 14A

FIG. 14B

FIG. 15A

FIG. 15B

Europäisches
Patentamt

European
Patent Office

Office européen
des brevets

# EUROPEAN SEARCH REPORT

**Application Number**

EP 10 17 8692

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 2 197 051 A2 (TOSHIBA KK [JP]) 16 June 2010 (2010-06-16) * figures 2-5,7,8,11 * ----- | 1-19 | INV. H01L33/00 |
| A | US 6 331 450 B1 (UEMURA TOSHIYA [JP]) 18 December 2001 (2001-12-18) * figures 2,3 * * column 5, line 41 - column 6, line 24 * ----- | 1-19 | |
| A | US 2010/025713 A1 (TAO CHIN-SAN [TW] ET AL) 4 February 2010 (2010-02-04) * figures 1A,1B,1C * * paragraph [0006] * ----- | 1-19 | |

| | | | TECHNICAL FIELDS SEARCHED (IPC) |
|---|---|---|---|
| | | | H01L |

The present search report has been drawn up for all claims

| Place of search | Date of completion of the search | Examiner |
|---|---|---|
| The Hague | 15 April 2011 | Adams, Richard |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 10 17 8692

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2011

| Patent document cited in search report | | Publication date | Patent family member(s) | | Publication date |
|---|---|---|---|---|---|
| EP 2197051 | A2 | 16-06-2010 | JP | 2010141176 A | 24-06-2010 |
| | | | US | 2010148198 A1 | 17-06-2010 |
| US 6331450 | B1 | 18-12-2001 | NONE | | |
| US 2010025713 | A1 | 04-02-2010 | NONE | | |

EPO FORM P0459

For more details about this annex : see Official Journal of the European Patent Office, No. 12/82